(19)

Europäisches
Patentamt
European
Patent Office
Office européen
des brevets

(11) **EP 3 281 972 A1**

(12) **EUROPEAN PATENT APPLICATION**
published in accordance with Art. 153(4) EPC

(43) Date of publication:
**14.02.2018 Bulletin 2018/07**

(21) Application number: **16776701.1**

(22) Date of filing: **08.04.2016**

(51) Int Cl.:
*C08J 11/08* (2006.01)        *B09B 3/00* (2006.01)
*H01L 31/048* (2014.01)

(86) International application number:
**PCT/JP2016/061605**

(87) International publication number:
**WO 2016/163535 (13.10.2016 Gazette 2016/41)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **10.04.2015 JP 2015080911**

(71) Applicant: **National Institute of Advanced
Industrial Science
and Technology
Tokyo 100-8921 (JP)**

(72) Inventor: **KAMO, Tohru
Tsukuba-shi
Ibaraki 305-8569 (JP)**

(74) Representative: **Gill Jennings & Every LLP
The Broadgate Tower
20 Primrose Street
London EC2A 2ES (GB)**

(54) **METHOD FOR SOLUBILIZING CROSSLINKED EVA, AND METHOD FOR RECOVERING RESOURCE FROM USED SOLAR CELL BY EMPLOYING SOLUBILIZATION METHOD**

(57)    There is provided a method for solubilizing crosslinked EVA which can dissolve crosslinked EVA within a short time such as about 60 minutes. Further, an object of the present invention is to provide a recovering method which uses such a solubilization method to solubilize, within a short time, the crosslinked EVA of a solar battery module containing metal and silicon and recovers valuable resources such as metal and silicon, and the recovering method includes treating the crosslinked EVA with a treatment solution at a temperature within a range from 100 to 300°C consisting essentially of a solvent selected from an alkyl-based alcohol having 5 to 12 carbon atoms and a phenol and an additive selected from an alkali, an oxoacid, and an oxoacid salt, to recover resources such as metal and silicon.

Figure 1

EP 3 281 972 A1

**Description**

TECHNICAL FIELD

The present invention relates to a method for solubilizing crosslinked EVA (ethylene-vinyl acetate copolymer) and a method for recovering valuable resource comprising recovering a material such as silicon and metal from a solar battery module by using the solubilization method.

BACKGROUND ART

Solar power generation systems including a solar battery module, which enable improvement in environmental issues such as reduction of carbon dioxide, are attracting attention along with hydro power generation and wind power generation among others, and therefore, the systems have remarkably spread in recent years, thanks to preferential treatments such as subsidies and power purchase systems.

However, the service life of solar battery modules is expected to last around 20 years, and its rapid development faces a demand for a measure against not only defective products generated in their manufacturing process but also the massive waste expected in the future of used solar battery modules.

Solar battery modules contain valuable resources, such as expensive valuable metals such as silver, silicon, and glass, and therefore, various studies are being conducted on the art of recovering these valuable resources from the modules in the measures taken against defective products and wastes.

The solar battery module has a stacked composite structure including a surface glass, solar battery cells, and a back surface protective film, and the solar battery cells are many cells made from silicon wafer and sealed with transparent crosslinked EVA. The crosslinked EVA is firmly bound to the surface glass, the back surface protective film, and a sealed material such as silicon and metal, and therefore, in the art of recovering valuable resources such as metal, silicon, and glass, it is a main issue to be solved to remove the crosslinked EVA from the valuable resources by using a simple means with relatively low costs so as not to significantly deteriorate the quality and value of the resources.

Patent Document 2 describes that a waste solar battery module is immersed in nitric acid with a surfactant and kept at a temperature of 50°C or higher, to decompose and remove crosslinked EVA and separate and recover in high efficiency the silicon wafer and tempered glass, that the recovered tempered glass is washed with an alkali solution to be recycled, and that the recovered silicon wafer is washed with an organic solvent, to be recycled as a silicon wafer having a clean surface.

Patent Document 3 describes that a solar battery module is immersed in an acid solution such as a nitric acid solution, an alkali solution such as a sodium hydroxide solution, or an organic solvent such as trichlorethylene, and then introduced into a combustion furnace to burn and decompose crosslinked EVA and extract a solar battery cell, and that the extracted solar battery cell is then subjected to a chemical treatment to remove a material such as an anti-reflection film and an electrode from the silicon substrate material, which is then extracted to be used to produce a silicon wafer or a ingot for solar battery.

Patent Document 4 describes that a solar battery module is immersed in an organic solvent containing more than 75% by weight of limonene, and thereby crosslinked EVA can be separated from glass after 200 to 600 hours.

The Patent Document 5 describes a method for disassembling a solar battery module, in which a solar battery module is immersed in an alcohol-based solvent containing 1 to 3% by weight of sodium hydroxide or potassium hydroxide and heated at 70 to 100°C, and thereby crosslinked EVA is decomposed, and in which filler made of crosslinked EVA and glass are removed, by using a piano wire with affixed diamond abrasive, from a module of two serially connected battery cells which consists of glass, crosslinked EVA of 0.6 mm in thickness, and polycrystalline silicon solar batteries, and then the solar batteries covered with the filler are immersed in an organic solvent containing 20% by weight of methanol, 25% by weight of n-butyl alcohol, 53% by weight of *N*-methyl-2-pyrrolidone, and 2% by mass of potassium hydroxide, and heated at 90°C for 3 hours, and thereby crosslinked EVA is decomposed and the solar batteries can be dissembled.

The Patent Document 6 describes that when the module of solar battery is immersed in a solution at 60°C of an alcohol-based solvent (benzyl alcohol, 40 to 85% by weight) and an anionic surfactant (sodium *meta*-xylene sulfonate, 5 to 35% by weight) dissolved in water, crosslinked EVA can be separated after 68 to 300 hours.

The Patent Document 7 describes that a module of solar battery was immersed in a neutral release agent (60 wt% of 1-tetradecene, 10% by weight of 3-methoxy-3-methyl-1-butyl acetate, 3% by weight of ethylhexyl diglycol, 1% by weight of benzyl alcohol, 0.2 wt% of an acetylene-based penetrant, 19.8% by weight of a nonionic surfactant, and water) kept warmed at 80°C for 16 hours, to separate a glass substrate, that the solar battery cell wrapped in crosslinked EVA was then able to be ground by milling into fine grains of crosslinked EVA, metallic fine grains consisting of silicon and metal, and metallic fine grains containing attached crosslinked EVA, and that the treatment took 16.5 hours in total and glass was able to be completely separated and recovered, with no EVA found.

In addition to the methods described above, methods have been studied or tried such as burning crosslinked EVA in atmosphere at 450 to 470°C for about 30 minutes, pyrolyzing crosslinked EVA at 520°C for about 90 minutes in an inert atmosphere, and decomposing/solubilizing crosslinked EVA in a solvent in a supercritical or subcritical state.

On the other hand, Patent Document 1 describes a method for dissolving a thermosetting resin product, although it is not an art for recovering valuable resources from a solar battery module, in which a thermosetting composition containing an unsaturated polyester resin is treated with a treatment solution consisting essentially of a hydrate of phosphoric acid or a hydrate of phosphoric acid salt, and in a specific example of which a salt of alkali metal and phosphoric acid is added to an organic solvent containing an alcohol-based solvent at a temperature of 170°C or more and 300°C or less, in which solution a sample product is heated at atmospheric pressure at a temperature of 20 to 200°C, and thereby the thermosetting composition is dissolved.

BACKGROUND ART

PRIOR ART REFERENCE

PATENT DOCUMENTS

Patent Document 1: JP-A-2003-27853
Patent Document 2: JP-A-2004-042033
Patent Document 3: JP-A-2005-311178
Patent Document 4: WO 2005/065852
Patent Document 5: JP-A-2009-214058
Patent Document 6: JP-A-2013-001806
Patent Document 7: JP-A-2014-104406

DISCLOSURE OF THE INVENTION

PROBLEM TO BE SOLVED BY THE INVENTION

Regarding the conventional arts as described above, the present inventors studied by themselves and recognized the following problems. The methods using a strong acid or alkali are problematic in that recovering valuable resources is difficult because the strong acid or alkali to be used in high concentration dissolves metal, causing increase in costs for treating the waste acid or alkali, although the methods can relatively easily decompose crosslinked EVA. The burning and pyrolyzing methods are problematic in that not only a doped composition or a carbonatious material diffuses into a silicon wafer body, thereby lowering the quality such as the purity of the silicon, but also a defect occurs such as the oxidation and melt diffusion of the electrode and solder and the adhesion of a carbonatious material to the cell, although they are relatively easy methods for removing crosslinked EVA. The method of separating EVA by using an organic solvent containing a large amount of limonene is not economically feasible as an industrial process because limonene is expensive and the treatment takes a long time (tens to hundreds of hours). The method of separating crosslinked EVA by using water containing an alcohol-based solvent and a neutral release agent is problematic in that the treatment takes a long time (tens to hundreds of hours) and in that crosslinked EVA cannot be sufficiently removed from silicon and metal. The method using a solvent in a supercritical or subcritical state is problematic, for example, in that it is expensive because it requires an expensive reactor that can withstand high temperature and high pressure, although the method can decompose and solubilize crosslinked EVA. The method of dissolving a thermosetting composition containing an unsaturated polyester resin was not directly applicable to the solubilization of crosslinked EVA. In the method of disassembling a solar battery module of Patent Document 5, crosslinked EVA can be decomposed by immersing a solar battery module in an alcohol-based solvent containing 1 to 3% by weight of sodium hydroxide and heating the solution at 70 to 100°C, but the crosslinked EVA was not able to be sufficiently solubilized under such a condition (Comparative Examples 1 and 2, as will be described below).

The present invention has been made in view of the problems in the conventional arts as described above, and it is an object of the invention to provide a method for solubilizing crosslinked EVA which can dissolve crosslinked EVA within a short time, such as about 60 minutes.

Further an object of the present invention is to use such a method to solubilize, within a short time, crosslinked EVA of a solar battery module containing metal and silicon, to recover valuable resources such as the metal and silicon.

MEANS FOR SOLVING THE PROBLEMS

The present inventors have conducted various tests and studies to solve the above-described problems, and consequently, obtained findings such as items (1) and (2) below.

(1) Crosslinked EVA used in products such as solar battery modules can be solubilized at a solubilization ratio of or near 100% even within a short treatment time of about 60 minutes, by using a treatment solution based on an alkyl-based alcohol having 5 to 12 carbon atoms or a phenol as a solvent and an alkali such as potassium hydroxide and sodium hydroxide, and an oxoacid such as sulphuric acid and a salt thereof as an additive, at about 100 to 300°C, a temperature near the boiling point of the solvent or slightly lower than that.

(2) When an alkyl-based alcohol having 5 to 12 carbon atoms is used as a solvent, an alkali such as potassium hydroxide and sodium hydroxide is preferable as an additive, and when a phenol is used, an oxoacid such as sulphuric acid is preferable as an additive.

The present invention has been completed based on the above findings, and the following invention is herein provided.

<1> A method for solubilizing crosslinked EVA comprising treating crosslinked EVA by using a treatment solution at a temperature within a range from 100 to 300°C, wherein the treatment solution consists essentially of a solvent selected from the group consisting of an alkyl-based alcohol having 5 to 12 carbon atoms and a phenol, and an additive selected from the group consisting of an alkali, an oxoacid, and an oxoacid salt.

<2> The method for solubilizing crosslinked EVA according to <1>, wherein one or two or more alkyl-based alcohols selected from the group consisting of an acyclic alkyl alcohol, a cyclic alkyl alcohol, and an aromatic alcohol are used as said solvent, and one or two or more alkalis selected from the group consisting of potassium hydroxide, sodium hydroxide, and lithium hydroxide are used as said additive, at the temperature of the treatment solution within a range from 100 to 300°C.

<3> The method for solubilizing crosslinked EVA according to <1> wherein an alkylphenol including an alkyl group having 1 to 5 carbon atoms is used as said solvent, an oxoacid or an oxoacid salt is used as said additive, at the treatment temperature within a range of 150 to 300°C.

<4> The method for solubilizing crosslinked EVA according to any one of <1> to <3>, wherein a treatment time is within 60 minutes and a solubilization ratio is 70% or more.

<5> The method for solubilizing crosslinked EVA according to any one of <1> to <4>, wherein the solubilization ratio is 100%.

<6> A method for recovering a valuable resource in a solar battery module, comprising performing the method for solubilizing crosslinked EVA according to any one of <1> to <5>, wherein the crosslinked EVA to be treated is contaminated by silicon and/or metal of a solar battery module, and a solubilized product of crosslinked EVA obtained by the method is separated, to recover the silicon and/or the metal.

<7> The method for recovering a valuable resource according to <6>, wherein the solubilized product is separated from a product to be treated, at the treatment temperature or a temperature in the vicinity thereof.

The present invention can include the following embodiments.

<8> The method for solubilizing crosslinked EVA according to any one of <2>, <4>, and <5>, wherein the acyclic alkyl alcohol is 2-ethyl-1-hexanol or 1-hexanol.

<9> The method for solubilizing crosslinked EVA according to any one of <3>, <4>, and <5>, wherein the additive is sulphuric acid.

<10> The method for solubilizing crosslinked EVA according to any one of <1> to <5>, <8>, and <9>, wherein the additive is within a range from 0.2 to 4.0% by weight with respect to the solvent.

<11> The method for solubilizing crosslinked EVA according to <10> wherein the additive is within a range from 0.5 to 5.0% by weight with respect to the solvent.

<12> The method for solubilizing crosslinked EVA according to any one of <1> to <5>, and <8> to <11>, wherein the additive is within a range from 5 to 100% by weight with respect to the crosslinked EVA.

<13> The method for solubilizing crosslinked EVA according to <12>, wherein the additive is within a range from 10 to 50% by weight with respect to the crosslinked EVA.

<14> The method for solubilizing crosslinked EVA according to any one of <1> to <5>, and <8> to <13>, wherein the solubilization is performed at atmospheric pressure.

<15> A method for recovering a valuable resource in a solar battery module, comprising performing the method for solubilizing crosslinked EVA according to any one of <8> to <14>, wherein crosslinked EVA to be treated is contaminated by silicon and/or metal of a solar battery module, and separating a solubilized product of the crosslinked EVA obtained by the method, to recover the silicon and/or the metal.

<16> The method of recovering a valuable resource according to <15>, wherein the solubilized product is separated from a product to be treated, at the treatment temperature or a temperature in the vicinity thereof.

EFFECT OF THE INVENTION

According to the present invention, significant effects as described in the following items (1) to (4) can be obtained.

(1) No method had been known to dissolve crosslinked EVA effectively, and the present invention has demonstrated that crosslinked EVA can be solubilized at a high solubilization ratio under a mild condition of temperature within a range from 100 to 300°C (preferably from 120 to 240°C) within a time of about 60 minutes, and even at normal pressure.

(2) When a treatment condition is set appropriately, the present invention can achieve a solubilizing ratio of near 100% within 60 minutes or even within a short time of about 15 to 30 minutes. Therefore, the present invention, when applied to the recovery of valuable resources from a solar battery module, can rapidly recover a resource such as metal and silicon sealed in crosslinked EVA, with the resource kept in a clean state free of not only the contamination by the crosslinked EVA, but also the oxidation of the metal, the precipitation of carbon, and the diffusion of the metal into the silicon.

(3) The method for solubilizing crosslinked EVA of the present invention uses neither strong acid nor strong alkali in high concentration, thereby placing only a small load on water treatment, and when applied to the recovery of valuable resources from a solar battery module, the method can recover metal and silicon without significant deterioration of the quality and value thereof.

(4) The method for solubilizing crosslinked EVA of the present invention uses neither an expensive solvent such as limonene, nor an expensive reaction apparatus necessary for a supercritical or subcritical reaction, thereby enabling lowering initial costs and running costs in comparison with conventional arts.

BRIEF DESCRIPTION OF THE DRAWINGS

[Fig. 1] Fig. 1 is a graph illustrating the influence of a ratio, (weight of additive/weight of EVA), on the solubilization ratio of crosslinked EVA for Example 3 of the present invention.

[Fig. 2] Fig. 2 is a graph illustrating the influence of solubilization time and (weight of additive/weight of EVA) on the solubilization ratio of crosslinked EVA for Example 4 of the present invention.

[Fig. 3] Fig. 3 is a graph illustrating the influence of treatment temperature on the solubilization ratio of crosslinked EVA for Example 5 of the present invention.

[Fig. 4] Fig. 4 is a graph illustrating the influence of solubilization time, treatment temperature, and kind of solvent on the solubilization ratio of crosslinked EVA for Example 7 of the present invention.

EMBODIMENTS FOR CARRYING OUT THE INVENTION

Hereinafter, embodiments for working the present invention will be described. The method for solubilizing crosslinked EVA includes treating crosslinked EVA with a treatment solution at 100 to 300°C, wherein the treatment solution consists essentially of an additive selected from the group consisting of an alkali, an oxoacid, and an oxoacid salt and, a solvent selected from the group consisting of an alkyl-based alcohol having 5 to 12 carbon atoms and a phenol.

A product to be treated that is subject to the method for solubilizing crosslinked EVA of the present invention contains crosslinked EVA as the whole or part thereof.

Examples of the product to be treated containing crosslinked EVA include, but are not limited to, a solar battery module (sometimes referred to as a solar battery panel, a solar panel *etc.*).

When the product to be treated is a product that contains crosslinked EVA not exposed on the surface thereof, an appropriate pre-treatment is made so that the crosslinked EVA may be at least exposed on the surface before the solubilization treatment of the present invention. Means for such a pre-treatment are not limited, and when the product to be treated is a solar battery module, crosslinked EVA can be exposed on the surface by dismantling the surrounding flame and mechanically removing the glass plate on the surface and the backsheet on the back surface. Crosslinked EVA can be cut or ground into a size suitable for solubilization during such a pre-treatment for exposing crosslinked EVA or a subsequent pre-treatment.

Crosslinked EVA solubilized in the present invention is crosslinked ethylene/vinyl acetate copolymer, which is poorly solubilized by an organic solvent such as xylene heated to about 110°C. The crosslinking ratio the polymer is usually within the range from 10 to 98% (preferably from 20 to 95%), but is not limited thereto.

According to the method for solubilizing crosslinked EVA of the present invention, crosslinked EVA, even having a crosslinking ratio as high as 90% or more, can be solubilized within a relatively short time equal to or less than about 60 minutes. Further, the method can achieve a solubilization ratio of 100%, and therefore, when the product to be treated is a product such as a solar battery module which contains valuable resources such as metal and silicon, the valuable resources can be recovered while separated from crosslinked EVA completely.

To calculate the crosslinking ratio, 1 g of crosslinked EVA is immersed in 100 ml of xylene, heated at 110°C for 24 hours, and then an insoluble fraction is collected by filtration using a wire mesh of 20 mesh, left at 120°C at reduced pressure for 10 hours, and then weighted, and the following equation is used for the calculation;

$$\text{crosslinking ratio } (\%) = 100 \times (W_1 / W_0).$$

$W_1$: weight (g) of collected insoluble fraction left at 120°C at reduced pressure for 10 hours.
$W_0$: initial weight of EVA, 1g.

In addition, to calculate the solubilization ratio, the insoluble fraction is collected after solubilization, by filtration using a wire mesh of 20 mesh, left at 120°C at reduced pressure for 10 hours, and then weighed, and the following formula is used for the calculation,

$$\text{solubilization ratio } (\%) = 100 \times (1 - W_1 / W_0).$$

$W_1$: weight (g) of collected insoluble fraction left at 120°C at reduced pressure for 10 hours.
$W_0$: initial weight of EVA (g).

In the present invention, the treatment solution used for solubilizing crosslinked EVA is a solution consisting essentially of an additive selected from the group consisting of an alkali, an oxoacid, and an oxoacid salt, and a solvent selected from the group consisting of an alkyl-based alcohol having 5 to 10 carbon atoms and a phenol.

Examples of the alkyl-based alcohol having 5 to 12 (preferably 5 to 10, more preferably 5 to 8) carbon atoms as a solvent include an acyclic alkyl alcohol and a cyclic alkyl alcohol, and these alkyl-based alcohols may be branched, or may be aromatic alcohols including an alkyl chain containing a hydroxyl group and an aryl group bound to the chain.

Examples of the acyclic alkyl alcohol include, but are not limited to, 1-pentanol, 1-hexanol, 1-heptanol, 1-octanol, 1-nonanol, 1-decanol, 1-undecanol, 1-dodecanol, 2-pentanol, 2-hexanol, 2-heptanol, 2-octanol, 2-ethyl-1-hexanol, 2-methyl-1-hexanol, 2-ethyl-1-heptanol, 2-methyl-1-heptanol, and 2-ethyl-1-octanol.

Examples of the cyclic alkyl alcohol include, but are not limited to, cyclopentanol, cyclohexanol, cycloheptanol, cyclooctanol, cyclononanol, cyclodecanol, cycloundecanol, cyclododecanol, 2-ethylcyclohexanol, and 2-methylcyclohexanol.

Examples of the aromatic alcohol include 1-phenylethanol, 2-phenylethanol, 1-phenyl-1-propanol, 1-phenyl-2-propanol, and 2-phenyl-1-propanol. Preferable examples of the alkyl-based alcohol include 2-ethyl-1-hexanol and 1-hexanol.

Examples of the phenol as a solvent include, but are not limited to, phenol and an alkylphenol containing an alkyl group having 1 to 5 carbon atoms. Examples of the alkylphenol containing an alkyl group having 1 to 5 carbon atoms include, but are not limited to, 3,5-dimethylphenol, cresol, 4-ethylphenol, and 4-*tert*-butylphenol.

The alkali as an additive is a hydroxide of alkali metal or of alkali earth metal and is preferably potassium hydroxide, sodium hydroxide, or lithium hydroxide, and more preferably potassium hydroxide or sodium hydroxide. Examples of the oxoacid and the oxoacid salt as an additive include, for example, sulphuric acid, nitric acid, phosphoric acid, and alkali metal salts thereof, and sulphuric acid is preferable.

The weight fraction of the additive to the solvent is within a range from 0.2 to 4.0%, preferably from 1.0 to 3.0%, and more preferably from 1.5 to 2.5%. The concentration of the additive of alkali or oxoacid in the treatment solution containing the solvents is low, and even when a product to be treated contains valuable resources such as metal and silicon, these valuable resources are unlikely to be invaded by the alkali and oxoacid.

As will be described in the following embodiments, alkali additives are preferable for solvents of alkyl-based alcohols and additives of oxoacids or oxoacid salts are preferable for solvents of phenols, in that crosslinked EVA can be solubilized at a high solubilizing ratio.

When the ratio of the weight of the alkali additive to that of crosslinked EVA (weight of only crosslinked EVA exclusive of the weight of contaminating silicon or metal) is lower than 5% by weight, the solubilization ratio is as low as, for example, about 20% or less. The solubilization ratio can be linearly increased with the increase in the ratio of the alkali additive from about 5% by weight, and can reach 100% with 25% by weight or more of the ratio of the alkali additive under a condition of solubilization time of 60 minutes. In addition, the solubilization time for achieving a predetermined solubilization ratio can be shortened with the increase in the ratio of the alkali additive. The upper limit of the amount of the alkali additive is not limited, but for example from the economical viewpoint, it can be set to 70% by weight or lower. Accordingly, a preferable ratio of the alkali additive to the weight of crosslinked EVA is within a range from 5 to 70% by weight, more preferably from 10 to 50% by weight, and still more preferably from 20 to 40% by weight.

The solution for solubilization treatment of the present invention preferably consists of only the above-described additive and solvent, but other alcohols and organic solvents can be contained in an amount within a range that does not greatly lower the solubilization ratio and the solubilization rate (for example, 10% by weight or less, preferably 5% by weight or less).

When the treatment temperature at which crosslinked EVA is treated with the solution for solubilization treatment is within the range from 100 to 300°C (preferably from 120 to 240°C), a relatively high solubilization ratio can be achieved even for a solubilization time of 60 minutes or shorter. When the treatment temperature is a temperature near the boiling point (boiling point ± 1°C) of a solvent to be used, or a temperature lower than the boiling point, for example, by 1 to 30°C (preferably 1 to 20°C), the evaporative loss of the solvent can be reduced during the treatment at atmospheric pressure.

When one or two or more kinds of alkyl-based alcohols selected from the group consisting of an acyclic alkyl alcohol, a cyclic alkyl alcohol, and an aromatic alcohol are used in combination as a solvent, the treatment temperature is within a range from 100 to 300°C, preferably from 130 to 210°C, and more preferably from 140 to 200°C.

When phenol or an alkylphenol including an alkyl group having 1 to 5 carbon atoms is used as a solvent, the treatment temperature is within a range from 150 to 300°C, preferably from 190 to 240°C, and more preferably from 200 to 240°C. Although the treatment atmosphere is desirably at atmospheric pressure from the economical viewpoint, it may be a pressurized atmosphere (1.5 atm or less, preferably 1.2 atm or less) or an atmosphere of reduced pressure (0.9 to 1 atm), and further, it may be an atmosphere containing an inert gas component such as nitrogen and carbon dioxide in a larger amount than that in air.

During the solubilization treatment, the treatment solution containing crosslinked EVA is preferably stirred by a well-known appropriate means in terms of the promotion of the solubilization.

After the solubilization of crosslinked EVA, the treatment solution containing the solubilized EVA (solubilized product) is subjected to the separation of the solubilized product from the treated product by filtration with a tool such as a wire mesh, and a valuable resource such as metal and silicon is recovered from the remaining insoluble fraction. The temperature during the separation of the solubilized product from the treated product is preferably the treatment temperature or a temperature near the treatment temperature (within the range from the treatment temperature - 20°C to the treatment temperature + 5°C, and more preferably from the treatment temperature - 10°C to the treatment temperature).

In particular, when the solubilization ratio of crosslinked EVA is 100%, the recovery of valuable resources is easy since crosslinked EVA is not contained in the insoluble fraction. The treatment solution after the filtration can be recycled and reused as a solvent for solubilization treatment after the solubilized EVA component is removed by an appropriate means such as distillation.

Although the mechanism of solubilizing crosslinked EVA by the solubilization method of the present invention has not yet been elucidated clearly, it can be attributed the ester bond contained in the crosslink between EVAs which is cleaved owing to transesterification with the alkyl-based alcohol in the treatment solution or alkali decomposition. In that case, since the main chain of EVA is not decomposed by the solubilization treatment, the solubilized EVA is expected to be recycled for a useful application.

The solubilization treatment of crosslinked EVA by the treatment solution may be either a batch treatment or a continuous treatment.

In the case of a batch treatment, the product to be treated may be input into the treatment solution before temperature raise, or it may be input thereinto during or after the temperature raise.

EXAMPLES

Hereinafter, the present invention will be described in more detail based on Examples, but the invention is not limited to such Examples.

(Example 1) <Solubilization test of crosslinked EVA under various conditions>

To a vessel containing 5.1 g of EVA (20.0 mm square, crosslinking rate of 83%) which is EVASKY, S-88, from Bridgestone Corporation, crosslinked at 150°C were added 100.0 g of 1-phenylethanol as a solvent, 1.7 g of potassium hydroxide as an additive, and a magnetic stir bar, and heated from room temperature to a treatment temperature of 204°C for about 20 minutes, and then the mixture was kept at the same treatment temperature for a solubilization time of 60 minutes while stirred by using a magnetic stirrer. After the solubilization, the sample, not cooled, was filtrated with a wire mesh of 20 mesh, and the recovered solid product was washed several times in tetrahydrofuran with an ultrasonic cleaner, and left as a trial at 50°C for 10 hours in a vacuum dryer, to remove the solvent. The trial solubilization ratio of EVA was 100.0%, based on the calculation using the following formula,

$$\text{trial solubilization ratio } (\%) = 100 \times (1 - W_1 / W_0).$$

$W_1$: weight (g) of collected insoluble fraction left at 50°C at reduced pressure for 10 hours.
$W_0$: initial weight (g) of EVA.

When the drying temperature at reduced pressure is 50°C, the solvent captured in the crosslinked EVA owing to its swelling is difficult to be removed completely, and therefore the trial solubilization ratio is estimated to be lower than the solubilization ratio defined in the paragraph [0026], and is, for example, about 80% for the solubilization ratio of 90%, and about 60% for the solubilization ratio of 80%. (However, when the solubilization ratio is nearly 100%, it is not significantly different from the trial solubilization ratio. In Example 3 or later, the residual solvent was completely removed using vacuum dry at 120°C in order to calculate the solubilization ratio defined in the paragraph [0026].) The trial solubilization ratio was obtained in the same manner as above except that at least one of the experimental conditions of kind of solvent, treatment temperature, weight of EVA, weight of solvent, kind of additive, and weight of additive was changed, and the result is illustrated in Table 1 together with the experimental conditions.

[Table 1]

| solvent | treatment temperature (°C) | solubilization time (min) | weight of EVA (g) | weight of solvent (g) | additive | weight of additive (g) | additive/EVA (g/g) | solubilization ratio (%) |
|---|---|---|---|---|---|---|---|---|
| 1-phenylethanol | 204 | 60 | 5.1 | 100.0 | KOH | 1.7 | 0.34 | 100.0 |
| 1-octanol | 195 | 60 | 5.1 | 100.0 | KOH | 1.7 | 0.34 | 100.0 |
| 1-heptanol | 176 | 60 | 5.1 | 100.1 | KOH | 1.7 | 0.33 | 100.0 |
| 1-hexanol | 157 | 60 | 5.1 | 100.1 | KOH | 1.7 | 0.34 | 100.0 |
| 1-pentanol | 138 | 60 | 5.1 | 100.1 | KOH | 1.7 | 0.33 | 87.7 |
| cyclohexanol | 161 | 60 | 4.0 | 80.0 | KOH | 1.3 | 0.33 | 100.0 |
| 1-phenylethanol | 204 | 60 | 5.1 | 100.1 | NaOH | 1.1 | 0.21 | 100 |
| 1-octanol | 195 | 60 | 5.0 | 100.4 | NaOH | 1.1 | 0.21 | 99.6 |
| 1-hexanol | 157 | 60 | 5.0 | 100.0 | NaOH | 1.1 | 0.21 | 98.8 |
| cyclohexanol | 161 | 60 | 5.1 | 100.3 | NaOH | 1.1 | 0.21 | 65.7 |
| ethylene glycol | 197 | 60 | 5.1 | 100.7 | NaOH | 1.1 | 0.21 | 0.0 |
| decalin | 190 | 60 | 5.0 | 100.0 | $H_2SO_4$ | 0.52 | 0.10 | 0.0 |
| 1,2,3,4-tetrahydronaphthalene | 200 | 60 | 5.0 | 100.0 | $H_2SO_4$ | 0.52 | 0.10 | 0.0 |
| 3,5-dimethylphenol | 222 | 60 | 5.1 | 100.0 | $H_2SO_4$ | 0.51 | 0.10 | 91 |
| cresol | 200 | 60 | 5.0 | 100.4 | $H_2SO_4$ | 0.54 | 0.11 | 100 |
| 4-ethylphenol | 219 | 60 | 5.1 | 100.1 | $H_2SO_4$ | 0.52 | 0.10 | 100 |
| 4-tert-buthylphenol | 238 | 60 | 5.1 | 100.2 | $H_2SO_4$ | 0.54 | 0.11 | 100 |

As is apparent from Table 1, high solubilization ratios of about 65% or more were exhibited when an acyclic alkyl alcohol such as 1-octanol, a cyclic alcohol such as cyclohexanol, an aromatic alcohol such as 1-phenylethanol, and a phenol such as cresol were used as a solvent, and potassium hydroxide, sodium hydroxide, and sulphuric acid were used as an additive, at about 120 to 240°C which was a treatment temperature set to be equal to or slightly lower than the boiling points of the respective solvents. The alkyl-based alcohols, whether they were acyclic or cyclic, exhibited high solubilization ratios of or near 100% when an alkali was used as an additive, however the acyclic alkyl-based alcohols exhibited higher solubilization ratios than those of the cyclic alcohols, even when the ratio of weight of the additive to that of EVA was relatively small. In addition, when phenols were used as a solvent and sulphuric acid was used as an additive, high solubilization ratios of 100% were exhibited even when the ratio of weight of the additive to that of EVA was relatively small. On the other hand, solubilization was not able to be achieved when a divalent alcohol such as ethylene glycol or a naphthalene-based solvent such as decalin was used as a solvent.

(Example 2) <Investigation test of influence of kind of additive on solubilization ratio>

A trial solubilization ratio was calculated to investigate the influence of kind of additive on solubilization ratio in the same manner as that in Example 1, mainly, with the kind of additive changed, the weight of additive set so that the amount of the additive might take an approximately constant molar number (0.025 to 0.03 mol) except for a case with no additive, and other conditions of kind of solvent, treatment temperature, solubilization time, weight of solvent, and sample size kept nearly unchanged (solvent, 1-hexanol: treatment temperature, 157°C: solubilization time, 30 minutes: weight of EVA, 5.1 g or 5.0 g: weight of solvent, 100.0 to 100.6 g: sample size, 20.0 mm). The result is illustrated in Table 2.

[Table 2]

| solvent | treatment temperature (°C) | sol ubilization time (min) | weight of EVA (g) | weight of solvent (g) | additive | weight of additive (g) | additive/EVA (g/g) | solubilization ratio (%) |
|---|---|---|---|---|---|---|---|---|
| 1-hexanol | 157 | 30 | 5.1 | 100.6 | no additive | 0.0 | 0.00 | 0.0 |
| 1-hexanol | 157 | 30 | 5.1 | 100.0 | $H_3PO_4$ | 2.9 | 0.57 | 0.0 |
| 1-hexanol | 157 | 30 | 5.0 | 100.2 | $Ca(OH)_2$ | 1.9 | 0.38 | 4.4 |
| 1-hexanol | 157 | 30 | 5.1 | 100.1 | LiOH | 0.6 | 0.12 | 19.5 |
| 1-hexanol | 157 | 30 | 5.1 | 100.0 | $K_3PO_4$ | 5.6 | 1.10 | 30.6 |
| 1-hexanol | 157 | 30 | 5.1 | 100.2 | NaOH | 1.1 | 0.21 | 91.1 |
| 1-hexanol | 157 | 30 | 5.1 | 100.1 | KOH | 1.7 | 0.33 | 100.0 |

As is apparent from Table 2, no solubilization occurred when the solvent was 1-hexanol, with no additive or with phosphoric acid as an additive. Further, a low solubilization ratio was exhibited when the additive was potassium phosphate, calcium hydroxide, or lithium hydroxide. In contrast, a high solubilization ratio was exhibited when the additive was potassium hydroxide, or sodium hydroxide and the ratio of weight of the additive to that of EVA was 20% by weight or higher.

(Example 3) <Investigation test of influence of (weight of additive/weight of EVA) on solubilization ratio>

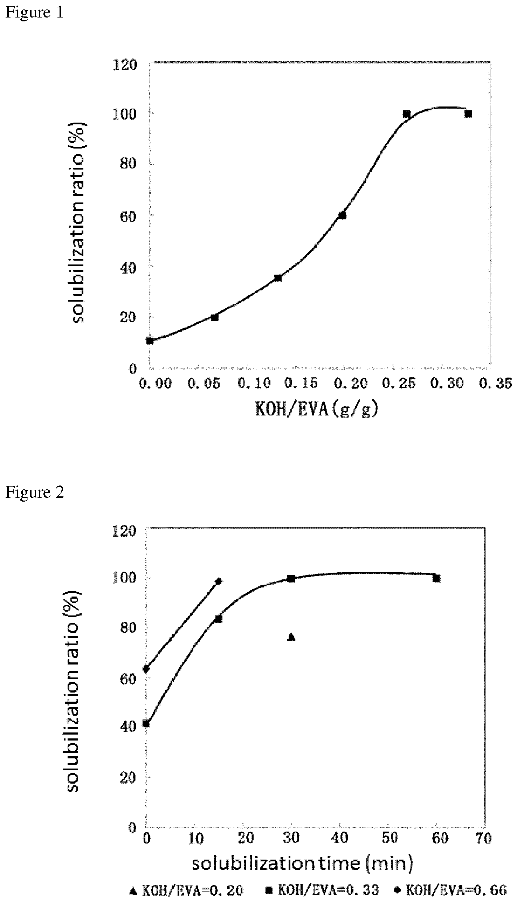

A cage made of a wire mesh of 20 mesh in a glass reaction vessel was lifted, without cooling after solubilization, along with a solid product be recovered in the cage, and then the product was washed several times in tetrahydrofuran by using an ultrasonic cleaner, dried at 120°C using a vacuum dryer for 10 hours, and then weighed, to a calculate solubilization ratio. A solubilization ratio was calculated to investigate the influence of (weight of additive/weight of EVA) on solubilization ratio, mainly, with the weight of EVA and/or that of the additive changed, and other conditions of solvent, treatment temperature, solubilization time, weight of solvent, additives, and sample size kept unchanged or nearly unchanged (solvent, 1-hexanol: treatment temperature, 157°C: solubilization time, 60 minutes: weight of solvent, 198.1 to 203 g: additives, KOH: sample size, 20.0 mm). The result is illustrated in Fig. 1 and Table 3.

[Table 3]

| solvent | treatment temperature (°C) | solubilization time (min) | weight of EVA (g) | weight of solvent (g) | additive | weight of additive (g) | additive/EVA (g/g) | **solubilization** ratio (%) |
|---|---|---|---|---|---|---|---|---|
| 1-hexanol | 157 | 60 | 10.0 | 198.1 | KOH | 3.3 | 0.33 | 99.80 |
| 1-hexanol | 157 | 60 | 10,0 | 200.0 | KOH | 2.6 | 0.26 | 99.70 |
| 1-hexanol | 157 | 60 | 10.0 | 200.0 | KOH | 2.0 | 0.20 | 59.84 |
| 1-hexanol | 157 | 60 | 10.0 | 200.0 | KOH | 1.3 | 0.13 | 35.44 |
| 1-hexanol | 157 | 60 | 10.0 | 203.0 | KOH | 0.7 | 0.07 | 19.76 |
| 1-hexanol | 157 | 60 | 10.0 | 200.0 | KOH | 0.0 | 0.00 | 10.90 |

As is apparent from the description of Table 3 and Fig. 1, the solubilization ratio increased almost linearly with the increase in (weight of additive/weight of EVA). Specifically, a solubilization ratio of about 30% was exhibited when the ratio of the weight of the additive to that of EVA was about 10% by weight, and a solubilization ratio of about 60% was exhibited for the ratio of about 20% by weight, and further, a solubilization ratio of or near 100% was exhibited for the ratio of about 25% by weight or higher.

(Example 4) <Investigation test of influence of solubilization time and weight of additive on solubilization ratio>

A solubilization ratio was calculated in the same manner as that in Example 3, to investigate the influence of solubilization time and weight of additive, i.e., (weight of additive/weight of EVA), on solubilization ratio, mainly, with the solubilization time and/or the weight of additive changed, and other conditions of solvent, treatment temperature, weight of EVA, weight of solvent, additive, and sample size kept unchanged or nearly unchanged (solvent, 1-hexanol: treatment temperature, 157°C: EVA weight, 10.0 g: solvent weight, 200 g or 198.1 g: additive, KOH: sample size, 20.0 mm). The result is illustrated in Fig. 2 and Table 4.

[Table 4]

| solvent | treatment temperature (°C) | solubilization time (min) | weight of EVA (g) | weight of solvent (g) | additive | weight of additive (g) | additive/EVA (g/g) | solubilization ratio (%) |
|---|---|---|---|---|---|---|---|---|
| 1-hexanol | 157 | 30 | 10.0 | 200.0 | KOH | 1.98 | 0.20 | 76.4 |
| 1-hexanol | 157 | 0 | 10.0 | 200.0 | KOH | 3.30 | 0.33 | 41.6 |
| 1-hexanol | 157 | 15 | 10.0 | 200.0 | KOH | 3.30 | 0.33 | 83.4 |
| 1-hexanol | 157 | 30 | 10.0 | 200.0 | KOH | 3.31 | 0.33 | 99.7 |
| 1-hexanol | 157 | 60 | 10.0 | 198.1 | KOH | 3.27 | 0.33 | 99.8 |
| 1-hexanol | 157 | 0 | 10.0 | 200.0 | KOH | 6.60 | 0.66 | 63.6 |
| 1-hexanol | 157 | 15 | 10.0 | 200.0 | KOH | 6.60 | 0.66 | 98.7 |

As is apparent from the description of Table 4 and Fig. 2, it was revealed that when the weight of the additive with respect to that of EVA was increased from 20% by weight to 66% by weight, the solubilization rate was accelerated and a time taken for solubilization ratio to get close to 100% was able to be shortened to about 15 minutes.

(Example 5) <Investigation test of influence of treatment temperature on solubilization ratio>

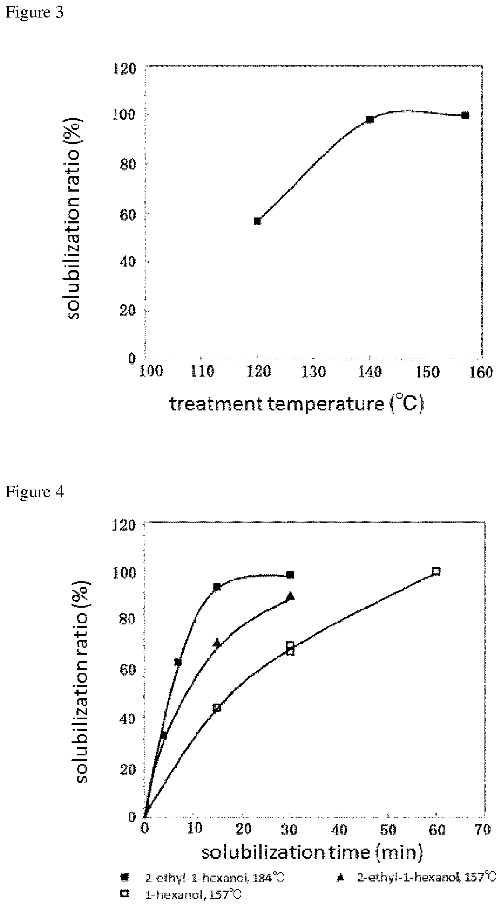

A solubilization rate was calculated in the same manner as that in Example 3, to investigate the influence of treatment temperature on solubilization ratio, mainly, with the treatment temperature changed, and other conditions of solvent, solubilization time, weight of EVA, weight of solvent, additive, weight of additive, and sample size kept unchanged or nearly unchanged (solvent, 1-hexanol: solubilization time, 60 minutes: weight of EVA, 10.0 g: weight of solvent, 200 g or 198 g: additive, KOH: weight of additive, 3.3 g: sample size, 20.0 mm). The result is illustrated in Table 5. Further, Fig. 3 illustrates a relation between the treatment temperature and the solubilization ratio.

[Table 5]

| solvent | treatment temperature (°C) | solubilization time (min) | weight of EVA (g) | weight of solvent (g) | additive | weight of additive (g) | additive/EVA (g/g) | solubilization ratio(%) |
|---|---|---|---|---|---|---|---|---|
| 1-hexanol | 120 | 60 | 10.0 | 200 | KOH | 3.3 | 0.33 | 57 |
| 1-hexanol | 140 | 60 | 10.0 | 200 | KOH | 3.3 | 0.33 | 98 |
| 1-hexanol | 157 | 60 | 10.0 | 198 | KOH | 3.3 | 0.33 | 100 |

As is apparent from the description in Table 5 and Fig. 3, the solubilization ratio was increased almost linearly from 60% to up to about 100% with the increase in the treatment temperature from about 120°C to about 150°C, when 1-hexanol was used as a solvent.

(Example 6) <Investigation test of influence of sample size on solubilization ratio>

A solubilization rate was calculated in the same manner as that in Example 3 to investigate the influence of sample size on solubilization ratio, with sample size changed, and other conditions of solvent, treatment temperature, solubilization time, weight of EVA, weight of solvent, additives, and weight of additive kept unchanged (solvent, 1-hexanol: treatment temperature, 157°C: solubilization time, 0 minutes: weight of EVA, 10.0 g: weight of solvent, 200 g: additive, KOH: weight of additive, 6.6 g). The result is illustrated in Table 6.

[Table 6]

| solvent | treatment temperature (°C) | solubilization time (min) | weight of EVA (g) | weight of solvent(g) | additive | weight of additive (g) | additive/EVA (g/g) | sample size (mm) | solubilization ratio(%) |
|---|---|---|---|---|---|---|---|---|---|
| 1-hexanol | 157 | 0 | 10.0 | 200.0 | KOH | 6.6 | 0.66 | 20.0 | 63.6 |
| 1-hexanol | 157 | 0 | 10.0 | 200.0 | KOH | 6.6 | 0.66 | 5.0 | 88.7 |

As is apparent from the description of Table 6, a solubilization ratio of 63.6% was exhibited when the sample size was 20.0 mm, and a solubilization ratio close to 90% was exhibited when the sample size was as small as 5.0 mm despite a solubilization time as short as 0 minutes.

(Example 7) <Investigation test of influence of kind of alkyl-based alcohol on solubilization ratio>

To a cage made of a wire mesh of 20 mesh were added 10.0 g of EVA crosslinked at 160°C (5.0 mm square, crosslinking ratio of 92%) which was crosslinked EVASKY, S-88, from Bridgestone Corporation, and a magnetic stir bar. To a vessel were added 200.0 g of 2-ethyl-1-hexanol as a solvent and 3.3 g of potassium hydroxide as an additive, and heated to 184°C, and upon the reaching of the temperature, the cage was dropped into the solvent to start solubilization for 4 minutes, with the solution kept stirred by using a magnetic stirrer, after which solubilization the cage was lifted from the solution along with a solid product to be recovered in the cage, and then the product was washed several times in tetrahydrofuran by using an ultrasonic cleaner, dried at 120°C using a vacuum dryer for 10 hours, and then weighed, to calculate solubilization ratio. The solubilization ratio of EVA was 33.4%. The solubilization ratio was calculated in substantially the same manner as above except that at least one of the experimental conditions of kind of solvent, treatment temperature, and solubilization time was changed, and the result is illustrated in Table 7 together with the experimental conditions, and the relation between solubilization time and solubilization ratio is also illustrated for each kind of solvent and each treatment temperature in Fig. 4.

[Table 7]

| solvent | treatment temperature (°C) | solubilization time (min) | weight of EVA (g) | weight of solvent (g) | additive | weight of additive (g) | additive/EVA (g/g) | sample size (mm) | solubilization ratio (%) |
|---|---|---|---|---|---|---|---|---|---|
| 2-ethyl-1-hexanol | 184 | 4 | 10.0 | 200 | KOH | 3.3 | 0.33 | 5 | 33.4 |
| 2-ethyl-1-hexanol | 184 | 7 | 10.0 | 200 | KOH | 3.3 | 0.33 | 5 | 63.0 |
| 2-ethyl-1-hexanol | 184 | 15 | 10.0 | 200 | KOH | 3.3 | 0.33 | 5 | 93.7 |
| 2-ethyl-1-hexanol | 184 | 30 | 100 | 200 | KOH | 3.3 | 0.33 | 5 | 98.6 |
| 1-hexa nol | 157 | 15 | 10.0 | 200 | KOH | 3.4 | 0.34 | 5 | 444 |
| 1-hexanol | 157 | 30 | 10.0 | 200 | KOH | 3.3 | 0.33 | 5 | 67.4 |
| 1-hexanol | 157 | 30 | 10.0 | 200 | KOH | 3.3 | 0.33 | 5 | 70.1 |
| 1-hexanol | 157 | 60 | 10.0 | 200 | KOH | 3.3 | 0.33 | 5 | 100.0 |
| 2-ethyl-1-hexanol | 157 | 15 | 10.0 | 200 | KOH | 3.3 | 0.33 | 5 | 71.2 |
| 2-ethyl-1-hexanol | 157 | 30 | 10.0 | 200 | KOH | 3.3 | 0.33 | 5 | 90.0 |

As is apparent from the description of Table 7 and Fig. 4, a higher solubilization rate was exhibited at a relatively low temperature of 157°C when 2-ethyl-1-hexanol was used as a solvent than when 1-hexanol was used. Further, it was revealed that an even higher solubilization rate was able to be exhibited at a treatment temperature increased to 184°C, when 2-ethyl-1-hexanol was used as a solvent.

(Comparative Example 1)

A model sample of solar battery module was fabricated which included a glass plate of 6 inch square and EVA (EVASKY, S-88, from Bridgestone Corporation, crosslinking ratio of 92%) thereon. The model sample was separated into the glass plate and EVA by using a hot knife, and to 5 g of the EVA (about 4cm square) were added 20 g of methanol, 25 g of butanol, 53 g of N-methyl-pyrrolidone, and 2 g of potassium hydroxide, and the sample was then left in the solvent at 90°C for 3 hours (heated within 30 minutes, kept 3 hours at the temperature, and then allowed to cool). After the treatment, the EVA was washed with methanol and immersed in THF (50°C). A very small fraction of the crosslinked EVA was dissolved or swelled owing to these treatments, but neither metal nor silicon plate was able to be recovered.

(Comparative Example 2)

To 10 g of EVA, which was EVASKY, S-88, from Bridgestone Corporation, crosslinked at 160°C (5 mm square, crosslinking rate of 92%) were added 40 g of methanol, 50 g of butanol, 106 g of N-methyl-pyrrolidone, and 4.7 g of potassium hydroxide, and heated while stirred by using a magnetic stirrer at 90°C for 1 hour. After the reaction, the sample was filtrated by using a wire mesh of 20 mesh, and the recovered solid product was left at 120°C for 10 hours in a vacuum dryer, to remove the solvent. The solubilization ratio of EVA was 13.6%.

INDUSTRIAL APPLICABILITY

According to the method for solubilizing crosslinked EVA of the present invention, crosslinked EVA can be solubilized for a short time of about 60 minutes at a solubilization ratio of or near 100%, and therefore the method can be effectively used for recovering valuable resources such as metal and silicon from a product to be treated, such as a solar battery module, that contains crosslinked EVA. Further, the method for solubilizing crosslinked EVA of the present invention can fluidize crosslinked EVA, with no cleavage of the main chain of EVA, and therefore the method can be used as a useful recycling method of crosslinked EVA.

**Claims**

1. A method for solubilizing crosslinked EVA comprising treating crosslinked EVA by using a treatment solution at a temperature within a range from 100 to 300°C, wherein said treatment solution consists essentially of a solvent selected from the group consisting of an alkyl-based alcohol comprising 5 to 12 carbon atoms and a phenol, and an additive selected from the group consisting of an alkali, an oxoacid, and an oxoacid salt.

2. The method for solubilizing crosslinked EVA according to claim 1, wherein one or two or more alkyl-based alcohols selected from the group consisting of an acyclic alkyl alcohol, an cyclic alkyl alcohol, and an aromatic alcohol are used as said solvent, and one or two or more alkalis selected from the group consisting of potassium hydroxide, sodium hydroxide, and lithium hydroxide are used as said additive, at a temperature of the treatment solution within a range from 100 to 300°C.

3. The method for solubilizing crosslinked EVA according to claim 1, wherein an alkylphenol comprising an alkyl group comprising 1 to 5 carbon atoms is used as said solvent, an oxoacid or an oxoacid salt is used as said additive, at the treatment temperature within a range from 150 to 300°C.

4. The method for solubilizing crosslinked EVA according to any one of claims 1 to 3, wherein a treatment time is within 60 minutes and a solubilization ratio is 70% or more.

5. The method for solubilizing crosslinked EVA according to any one of claims 1 to 4, wherein the solubilization ratio is 100%.

6. A method for recovering a valuable resource in a solar battery module, comprising performing the method for solubilizing crosslinked EVA according to any one of claims 1 to 5, wherein crosslinked EVA to be treated is contaminated by silicon and/or metal of a solar battery module, and a solubilized product of crosslinked EVA obtained by the method is separated, to recover the silicon and/or the metal.

7. The method for recovering a valuable resource according to claim 6, wherein a solubilized product is separated from a product to be treated at the treatment temperature or a temperature in the vicinity thereof.

Figure 1

Figure 2

Figure 3

Figure 4

25

## INTERNATIONAL SEARCH REPORT

| International application No. |
| --- |
| PCT/JP2016/061605 |

A.    CLASSIFICATION OF SUBJECT MATTER
*C08J11/08*(2006.01)i, *B09B3/00*(2006.01)i, *H01L31/048*(2014.01)i

According to International Patent Classification (IPC) or to both national classification and IPC

B.    FIELDS SEARCHED

Minimum documentation searched (classification system followed by classification symbols)
B09B1/00-5/00, B29B17/00, C08J11/00

Documentation searched other than minimum documentation to the extent that such documents are included in the fields searched
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
| --- | --- | --- |
| X<br>Y | JP 2009-214058 A  (Sharp Corp.),<br>24 September 2009 (24.09.2009),<br>paragraphs [0015], [0022], [0023], [0026]<br>(Family: none) | 1-2,4-7<br>6-7 |
| X | JP 2014-507529 A  (Saperatec GmbH),<br>27 March 2014 (27.03.2014),<br>paragraph [0011]; example 2<br>& US 2013/0319618 A1<br>paragraph [0014]; example 2<br>& WO 2012/101189 A1      & EP 2668226 A1<br>& CN 103370366 A          & KR 10-2014-0031194 A | 1-2,4-7 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    06 May 2016 (06.05.16) | Date of mailing of the international search report<br>    17 May 2016 (17.05.16) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2016/061605

C (Continuation).    DOCUMENTS CONSIDERED TO BE RELEVANT

| Category* | Citation of document, with indication, where appropriate, of the relevant passages | Relevant to claim No. |
|---|---|---|
| X | JP 09-040801 A  (Mitsui Petrochemical Industries, Ltd.), 10 February 1997 (10.02.1997), paragraphs [0001], [0005], [0011], [0016], [0018] (Family: none) | 1,3-5 |
| Y | | 6-7 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003027853 A
- JP 2004042033 A
- JP 2005311178 A
- WO 2005065852 A
- JP 2009214058 A
- JP 2013001806 A
- JP 2014104406 A